(19) **Europäisches Patentamt / European Patent Office / Office européen des brevets**

(11) **EP 3 828 554 B1**

(12) **FASCICULE DE BREVET EUROPEEN**

(45) Date de publication et mention de la délivrance du brevet:
**13.03.2024 Bulletin 2024/11**

(21) Numéro de dépôt: **20204772.6**

(22) Date de dépôt: **29.10.2020**

(51) Classification Internationale des Brevets (IPC):
***G01R 15/20*** *(2006.01)*

(52) Classification Coopérative des Brevets (CPC):
**G01R 15/202; G01R 15/205; G01R 15/207**

(54) **DISPOSITIF PORTATIF DE MESURE DE COURANT SANS CONTACT PAR CHAMPS MAGNÉTIQUES INDUITS**

TRAGBARE KONTAKTLOSE VORRICHTUNG ZUR STROMMESSUNG MIT HILFE VON INDUZIERTEN MAGNETFELDERN

PORTABLE CONTACTLESS DEVICE FOR MEASURING CURRENT BY INDUCED MAGNETIC FIELDS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.11.2019 FR 1913250**

(43) Date de publication de la demande:
**02.06.2021 Bulletin 2021/22**

(73) Titulaire: **CHAUVIN ARNOUX**
**92600 Asnières-sur-Seine (FR)**

(72) Inventeurs:
- **PION, Francisque**
  **75018 Paris (FR)**
- **AIT EL FAQIR, Marouane**
  **78018 Paris (FR)**

(74) Mandataire: **Cabinet Beau de Loménie**
**158, rue de l'Université**
**75340 Paris Cedex 07 (FR)**

(56) Documents cités:
**WO-A1-2013/051567     US-A1- 2019 146 009**

## Description

Domaine Technique

La présente invention se rapporte au domaine des mesures de courant sans contact et concerne plus particulièrement un dispositif de mesure par champs magnétiques induits.

Technique antérieure

Les capteurs de courant assurant une mesure sans contact sont bien connus, comme les capteurs à effet Hall, les boucles de Rogowski, les magnétorésistances, les fluxgates ou encore les dispositifs magnéto-optiques. Toutefois, ces capteurs nécessitent d'entourer le conducteur parcouru par le courant à mesurer et un tel placement n'est pas toujours possible ou souhaité. De tels capteurs sont divulgués dans US 2019/146009 A1 et WO 2013/051567 A1. En particulier, US 2019/146009 A1 montre un dispositif de mesure portatif sans contact d'un courant I traversant un conducteur électrique, le dispositif comportant un module de mesure et un module de traitement.

Exposé de l'invention

La présente invention a donc pour objet un dispositif de mesure de courant sans contact portatif qui ne nécessite pas un enserrement du conducteur pour effectuer cette mesure. Un but de l'invention est aussi d'éviter que la mesure de courant ne soit perturbée par les autres conducteurs présents dans l'environnement du conducteur objet de la mesure. Encore un but de l'invention est d'obtenir une mesure précise ayant une grande dynamique permettant de couvrir une grande plage de mesure de courant, typiquement de 1 à 100 Ampères.

Ces buts sont atteints par un dispositif de mesure portatif sans contact d'un courant I traversant un conducteur électrique, le dispositif comportant un module de mesure et un module de traitement, le module de mesure, configuré pour être tenu par un opérateur en contact du conducteur dans un plan P sensiblement orthogonal à ce conducteur et en regard et sans enserrement de ce conducteur, comportant une première pluralité de capteurs de champs magnétiques, et le module de traitement étant configuré pour effectuer une combinaison linéaire déterminée de la pluralité de signaux délivrés par la première pluralité de capteurs de champs magnétiques, de sorte à réaliser un filtrage spatial angulaire isolant le courant I à mesurer d'autres courants perturbateurs parcourant d'autres conducteurs.

Par ce filtrage spatial, il est possible de garantir une sélectivité angulaire appropriée au dispositif pour permettre d'isoler le courant recherché parmi des courants perturbateurs l'entourant avec une erreur minimale (typiquement une erreur maximale inférieure à 1%).

Avantageusement, le filtrage spatial angulaire est réalisé dans une zone prédéfinie de l'espace, limitée à un secteur circulaire défini par un angle $2\alpha$ et un rayon d et centrée sur le conducteur électrique disposé à une distance déterminée $r + d0$ d'un centre de la première pluralité de capteurs, r étant le rayon de la première pluralité de capteurs, d0 la distance de mesure et $r + d0 < d$.

De préférence, le module de mesure comporte l'une des formes suivantes : circulaire, elliptique, rectangulaire, carrée, en étoile ou en T et les capteurs de champs magnétiques sont répartis à la périphérie du module de mesure.

Avantageusement, les capteurs de champs magnétiques ont une sensibilité maximale tangentielle et/ou radiale.

De préférence, les capteurs de champs magnétiques sont choisis parmi les capteurs suivants : capteurs à effet Hall, capteurs GMR ou AMR, capteurs à porte de flux et sont au nombre de 2 à 30.

Avantageusement, lorsque le module de mesure présente une forme circulaire, le module de traitement est configuré pour assurer un balayage circulaire de la zone passante du filtre par une permutation de ses coefficients pondérateurs.

De préférence, le module de traitement est configuré pour reconstruire une image dans le plan P de la disposition angulaire des sources magnétiques formées par les autres conducteurs présents autour du module de mesure. Lorsque chaque capteur magnétique est formé de trois capteurs identiques disposés orthogonalement, le module de traitement peut être configuré pour reconstruire une image de l'environnement magnétique autour du module de mesure.

Avantageusement, pour couvrir une plus grande plage de mesure de courant, les capteurs de champs magnétiques alternent des capteurs à forte sensibilité de type à porte de flux et des capteurs à faible sensibilité de type à effet Hall.

De préférence, pour déterminer la distance de mesure d0, le dispositif de mesure peut comporter un doigt de palpation rétractable disposé à l'extrémité du module de traitement et présentant une position de repos et une position déployée, le passage de l'une à l'autre de ces deux positions distantes d'une distance prédéterminée s'effectuant par un bouton poussoir actionnable par l'opérateur ou encore comporter en outre une deuxième pluralité de capteurs de champs magnétiques dont le centre est espacé d'une distance prédéterminée $\Delta d0$ du centre de la première pluralité de capteurs.

Brève description des dessins

D'autres caractéristiques et avantages de la présente invention ressortiront de la description faite ci-dessous, en référence aux dessins annexés qui en illustrent un exemple de réalisation dépourvu de tout caractère limitatif et sur les lesquels :

[Fig. 1] la figure 1 représente schématiquement en perspective un premier exemple de dispositif de mesure de courant selon l'invention,

[Fig. 2] la figure 2 est un schéma synoptique du traitement mis en oeuvre dans le dispositif de mesure de courant de la figure 1,

[Fig. 3] la figure 3 est le résultat d'un filtrage avec un premier gabarit sur $\alpha$ utilisé dans le traitement du dispositif de mesure de courant selon l'invention,

[Fig.4] la figure 4 est le résultat d'un filtrage avec un second gabarit sur d utilisé dans le traitement du dispositif de mesure de courant selon l'invention, et

[Fig.5] la figure 5 illustre en perspective un second exemple de dispositif de mesure de courant selon l'invention.

Description des modes de réalisation

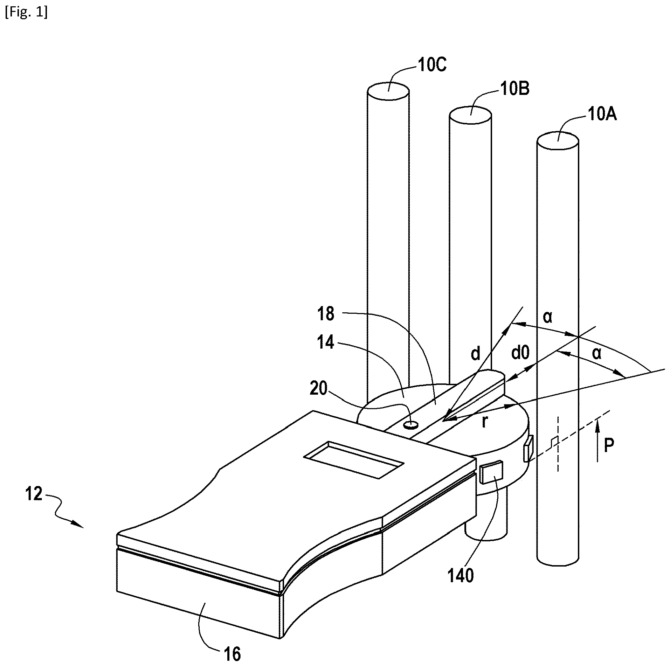

Sur la figure 1 en regard et à distance d'un conducteur 10A dont on cherche à mesurer sans l'enserrer le courant I le traversant, est positionné, dans un plan P orthogonal à ce conducteur, un premier exemple de dispositif portatif de mesure de courant sans contact 12 selon l'invention. Le conducteur instrumenté 10A est par exemple disposé au côté de deux autres conducteurs 10B, 10C dans un même plan perpendiculaire au plan P. Ces deux conducteurs sont également parcourus par des courants et constituent des éléments perturbateurs pour la mesure du courant I traversant le conducteur instrumenté 10A.

Selon l'invention, le dispositif de mesure comporte essentiellement un module de mesure 14 et un module de traitement 16, le module de mesure étant disposé à l'extrémité du module de traitement qui extérieurement présente avantageusement une forme de poignée permettant une préhension facile par un opérateur effectuant la mesure.

Le module de mesure 14 est constitué d'une pluralité de capteurs sensibles aux champs magnétiques, compris entre 2 et 30 et typiquement 8, formant une constellation et répartis sur 360°, de préférence régulièrement à la périphérie de ce module. Qu'ils soient répartis régulièrement ou non, la position de chacun des capteurs est connue avec précision, et ensemble ils n'assurent pas un enserrement du conducteur d'intérêt, au contraire des dispositifs de l'art antérieur.

Les capteurs de champs magnétiques pouvant être utilisés pour ce module sont typiquement des capteurs à effets Hall, des capteurs dits XMR, c'est-à-dire à magnétorésistance anisotropique (AMR) ou à magnétorésistance géante (GMR) ou encore des capteurs à porte de flux (fluxgate).

Dans l'exemple illustré, ce module de mesure présente une forme sensiblement circulaire mais une forme elliptique ou carrée est aussi possible. De même, il pourrait être envisagé une forme en croix ou en T, la barre et la jambe du T étant disposées dans le plan normal au conducteur d'intérêt, le choix de la forme la plus appropriée résultant du type de capteurs utilisé et des performances recherchées, notamment en matière de filtrage des signaux magnétiques issus de ces capteurs.

Les capteurs, quels que soient leurs types, présentant généralement une orientation de mesure privilégiée ou un axe de sensibilité maximale, il conviendra de rechercher préférentiellement des capteurs sensibles tangentiellement au module de mesure. Toutefois, une orientation radiale (dans le cas d'une constellation circulaire, elliptique ou carrée) peut être envisageable de sorte qu'une utilisation conjointe dans un même module, de capteurs à orientation radiale et à orientation tangentielle est aussi possible.

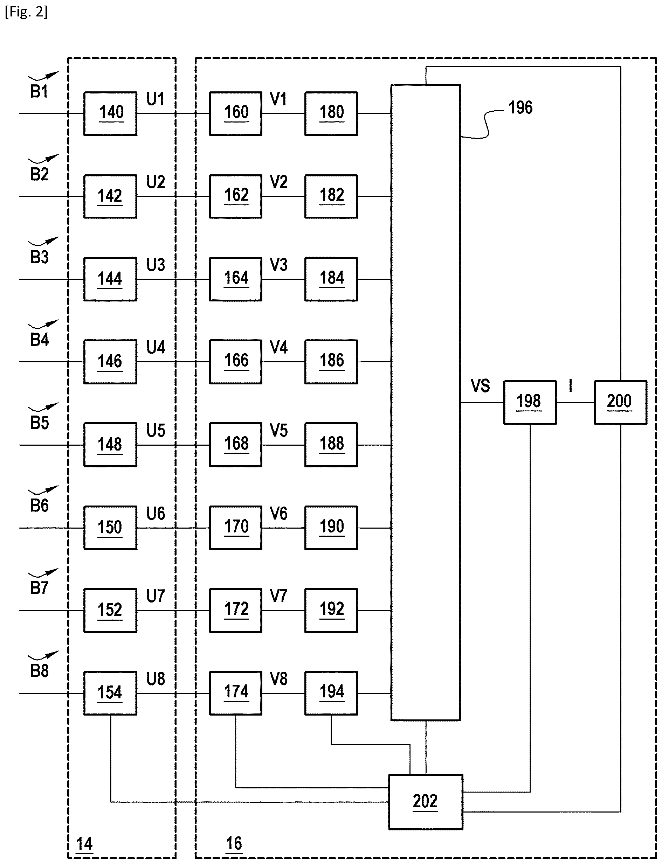

Le module de traitement 16 est maintenant décrit en regard de la figure 2 qui montre un synoptique simplifié de ce module qui reçoit de chacun des capteurs 140-154 (c'est-à-dire 8 capteurs dans l'exemple non limitatif illustré) formant la constellation du module de mesure 14, une première tension U1-U8 représentative du champ magnétique B1-B8 relevé au niveau de chacun de ces capteurs. Cette tension U1-U8 est délivrée à un circuit de compensation de gain 160-174 qui permet de compenser les différentes dispersions de gain inhérentes à chacun des capteurs et qui délivre une seconde tension normalisée V1-V8.

Selon le type de capteur, par exemple lors de l'emploi de capteurs AMR qui présentent des tensions de sortie très faibles (de l'ordre de quelques millivolts), ce circuit de compensation de gain peut aussi assurer une amplification du signal reçu.

Chacune des secondes tensions normalisées et éventuellement amplifiées V1-V8 est ensuite numérisée dans un convertisseur analogique-numérique 180-194 avant d'être communiqué à une unité de traitement 196 de type microcontrôleur (par exemple le STM32 de la société STM Microelectronics intégrant des mémoires vive et flash) ou analogue (ASIC ou FPGA par exemple) dans lequel ces tensions seront traitées par un filtrage numérique approprié, comme il sera explicité plus avant, pour restituer une tension VS caractéristique du signal de champ correspondant au seul champ magnétique émis par le courant I traversant le conducteur 10A.

Un circuit final de calibration 198 permet de passer de cette valeur de tension à celle du courant mesuré selon une équation de proportion connue

$$Imes = \frac{2\pi\,Kcal\,d_0}{\mu_0}\,Vs$$

où $\mu_0$ est la perméabilité dans le vide, d0 la distance de mesure et Kcal un paramètre de calibration déterminé préalablement en usine par des essais sur la base d'un courant calibré connu (typiquement 1A) et de courants perturbateurs également connus (par exemple variant de 10 à 400A). La détermination de la distance de mesure d0 peut par exemple être effectué au moyen d'un dispositif palpeur comme il sera décrit plus avant.

Le courant I ainsi déterminé est alors converti en valeur efficace et affiché sur un afficheur 200 du dispositif (d'autres paramètres comme la fréquence et la valeur moyenne continue peuvent éventuellement aussi être affichées). L'ensemble de ces composants est bien évidemment alimenté par une batterie 202 rechargeable ou non, typiquement de 5V, dont le niveau de charge est par exemple visible sur l'écran d'affichage qui est de préférence tactile. En liaison avec le microcontrôleur, cet écran peut aussi afficher un certain nombre d'autres états permettant de vérifier le bon fonctionnement du dispositif.

Conformément à l'invention, le filtrage numérique réalisé dans l'unité de traitement 196 consiste en une combinaison linéaire déterminée des valeurs de tensions normalisées $V_i$ représentatives des champs magnétiques relevés par les différents capteurs, soit $VS = \Sigma F_i \times V_i$, i étant le nombre de capteurs du module de mesure.

Dans l'exemple illustré à la figure 1 d'une constellation de huit capteurs, on obtient la relation suivante correspondant à un filtre d'ordre 8 de coefficients pondérateurs F1 à F8 : $VS = F1V1 + F2V2 + F3V3 + F4V4 + F5V5 + F6V6 + F7V7 + F8V8$

Cette combinaison linéaire déterminée tend à réaliser un filtrage spatial angulaire permettant d'isoler le courant I à mesurer de courants perturbateurs parcourant d'autres conducteurs que le conducteur d'intérêt. Ce filtrage spatial angulaire présente la propriété de n'être sensible qu'aux champs émis par des conducteurs situés dans une région prédéfinie de l'espace définie comme la zone d'espace passante. Cette zone passante est avantageusement un secteur circulaire d'angle $2\alpha$ ($-\alpha$, $+\alpha$) et de rayon d, centré sur le conducteur ciblé (présent en $\alpha = 0$), lequel est disposé à une distance donnée $r + d0$ du centre de la constellation de capteurs (r étant le rayon de la constellation de capteurs et $r + d0 < d$). Le rayon r de la constellation de capteurs est de préférence compris entre 1 et 5 cm, typiquement 3 cm et la distance d0 comprise entre 1 et 10 mm.

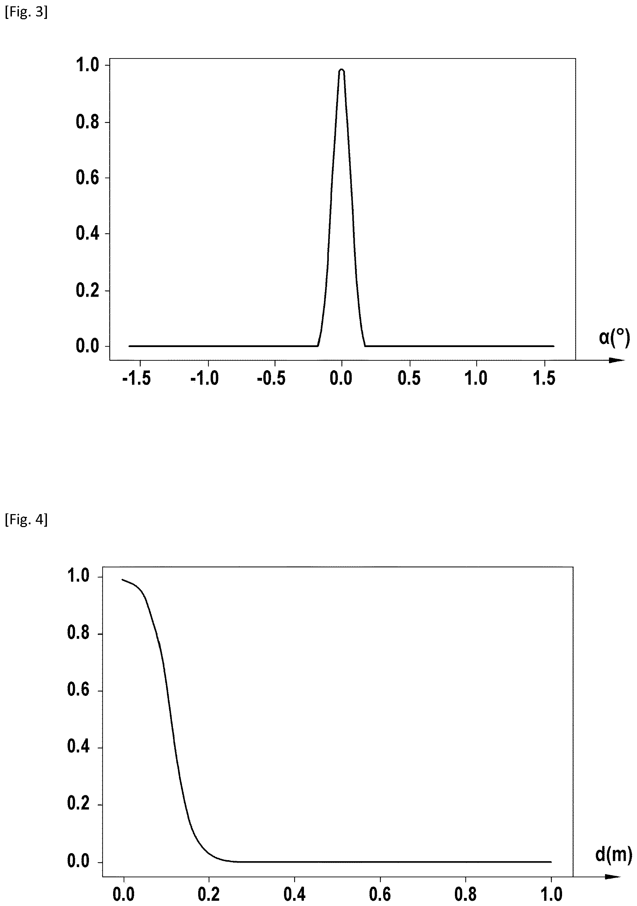

Pour réaliser ce filtrage spatial angulaire et comme le montrent les figures 3 et 4, il est mis en place un gabarit spatial permettant de spécifier le comportement du filtre par une délimitation des zones passante et atténuée (ou coupée) traduisant la sensibilité recherchée. Plus précisément, il est prévu un premier gabarit sur $\alpha$ (la figure 3 illustre le résultat du filtrage) et un second gabarit sur d (la figure 4 illustre le résultat du filtrage) pouvant chacun être constitué d'une simple fonction porte rectangulaire centrée sur la direction de la source ciblée (typiquement $\alpha$ va de $-\pi/2$ à $\pi/2$ et d est inférieure à 1m). Mais il est clair qu'une fonction de Hamming ou de Hanning ou toute autre fonction de fenêtrage similaire comme celle de Blackman ou de Kaiser est aussi envisageable.

Les deux gabarits du filtre ainsi définis, la synthèse du filtre souhaité peut être obtenue simplement par un processus itératif au moyen d'un logiciel de synthèse connu comme PYTHON. Plus précisément, il s'agit de chercher une combinaison optimale de mesures qui permette de respecter ces deux gabarits représentant le filtrage souhaité (pour cela, on dispose pour chaque point du plan, de mesures de champ données par une constellation de N capteurs). Cela revient à minimiser la distance du filtre au gabarit via une méthode de moindres carrés bilinéaires. Ce processus de calibration effectué classiquement en usine permet la détermination des coefficients pondérateurs $F_i$ du filtre numérique et dépendent notamment de la position et de l'orientation de ces capteurs. Ainsi, pour un module de mesure circulaire dont le rayon de la constellation est de 3cm comportant huit capteurs à effet Hall répartis régulièrement sur 360° et orientés tangentiellement avec une distance de mesure d0 de 3mm, on obtient les coefficients pondérateurs suivants : F1=F8=0,105692149 ; F2=F7=0,217712759 ; F3=F6=0,378621237 et F4=F5=1

En outre, afin d'augmenter la dynamique de mesure, il est avantageux de recourir à des capteurs différents. Par exemple, la constellation peut comporter à la fois des capteurs à porte de flux (par exemple le capteur DRV425 de la société Texas Instrument) très sensible avec une dynamique linéaire +/- 2mT et des capteurs à effet Hall moins sensible mais qui peuvent monter jusqu'à +/-100 mT (par exemple le capteur EQ733L de la société AKM semiconductor Inc). Cette réalisation combinant des capteurs à faibles et fortes sensibilités disposés alternativement permet de couvrir une grande plage de mesure de courant (typiquement de 1A à 100A). On notera que ces capteurs peuvent aussi être disposés de part et d'autre d'une même carte électronique de façon à minimiser l'espace requis.

On notera également que lorsque la constellation présente une forme circulaire, il est possible au niveau de l'unité de traitement, par un simple jeu de permutation des coefficients pondérateurs du filtre numérique, de déplacer la zone d'espace passante du lobe de directivité de façon circulaire et ainsi de cartographier le champ magnétique dans le plan du capteur sans avoir à modifier son orientation. En effet, la constellation restant fixe, la zone passante décrit un disque autour d'elle et balaye ainsi l'espace environnant la constellation. Dans cette configuration particulière, après une rotation complète, on peut alors reconstruire l'image de la disposition angulaire des sources magnétiques autour de la constellation et d'afficher celle-ci sur l'afficheur. Avec trois capteurs identiques, disposés orthogonalement en lieu et place de chaque capteur (soit 24 capteurs dans une configuration semblable à celle de la figure 1), la cartographie devient 3D. Il devient possible de reconstruire une image de l'environnement magnétique du dispositif de mesure.

Enfin, le dispositif de mesure de l'invention comporte un doigt de palpation rétractable 18 disposé également à l'extrémité du module de traitement 16 et qui présente deux positions distinctes $d0_1$, $d0_2$ et stables, une position de repos et une position déployée, ces deux positions n'étant distantes l'une de l'autre que d'un $\Delta d0$ connu de quelques millimètres, typiquement 3 mm (avec $d0_1$ = 2mm et $d0_2$ = 5mm).

Le passage de l'une à l'autre de ces deux positions est effectué par l'opérateur simplement grâce à un bouton poussoir 20 et permet avec une même constellation de capteurs, en obtenant deux mesures de courant sur un même conducteur, de déterminer la distance de mesure d0 à ce conducteur.

En effet, le champ magnétique est inversement proportionnel à la distance d0 -> B1 donnant une sortie VS1, la distance est modifiée
d0 + $\Delta$d0 -> B2 donnant une sortie VS2

$$\begin{cases} B_1 = \dfrac{A}{d_0} \\ B_2 = \dfrac{A}{(d_0 + \Delta d_0)} \end{cases}$$

La solution analytique est trouvée par combinaison :

$$\frac{B_1}{B_2} = \frac{A}{d_0} \times \frac{(d_0 + \Delta d_0)}{A} \leftrightarrow \frac{B_1}{B_2} = 1 + \frac{\Delta d_0}{d_0}$$

D'où la solution :
$$d_0 = \frac{\Delta d_0}{\frac{B_1}{B_2} - 1} = \text{avec } B_1 > B_2$$
qui est identique lorsque l'on remplace B1/B2 par VS1/VS2 :
$$d_0 = \frac{\Delta d_0}{\frac{V_{s1}}{V_{s2}} - 1} = \text{avec } V_{s1} > V_{s2}$$

Le $\Delta d_0$ est une constante du dispositif palpeur.

Il est donc possible à partir de différentes tensions de mesures issues de la constellation de capteurs de déterminer cette distance d0, distance réelle de mesure qui permettra d'effectuer si nécessaire un correctif des différentes mesures (le dispositif de mesure étant préalablement calibré en usine à une distance de calibrage pouvant en effet être distincte de cette distance réelle de mesure).

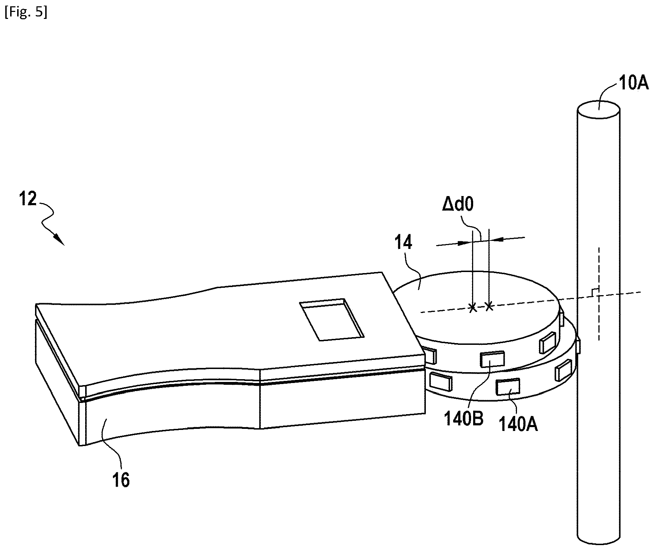

On pourra noter, comme l'illustre la figure 5, que ce dispositif palpeur peut être remplacé par une deuxième constellation de capteurs 140B dont le centre est distant de $\Delta$d0 du centre de la première constellation 140A. Ce second exemple de dispositif de mesure de courant selon l'invention permet de remplacer le déplacement physique du dispositif par une commutation électronique d'une constellation à l'autre, la constellation la plus extérieure étant en contact avec le conducteur d'intérêt 10A.

Le fonctionnement du dispositif de mesure est particulièrement simple, comme il sera expliqué ci-après.

L'opérateur ayant en main le dispositif et après s'être assuré que la charge de la batterie est suffisante (un simple contact sur l'afficheur permet de l'extraire de son état de veille et de fournir cette information), il le place en regard du conducteur dont le courant est à mesurer, dans un plan sensiblement orthogonal à ce conducteur, jusqu'à venir en contact avec le doigt de palpation rétractable. La mise en compression du doigt de palpation rétractable sur le conducteur a pour effet de déclencher automatiquement une première mesure de champ magnétique par la constellation de capteurs. La rétractation du doigt de palpation dans sa seconde position stable par l'action sur le bouton poussoir déclenchera une seconde mesure de champ magnétique permettant à la fois la détermination automatique de la distance d0 et celle de la valeur du courant I détecté, l'affichage de cette valeur s'effectuant en effet quasi instantanément (au plus quelques centaines de millisecondes selon les moyens de calcul utilisés). Lorsque le dispositif de mesure de courant comporte deux constellations de capteurs, les première et seconde mesures peuvent par contre être faites simultanément dès le contact avec le conducteur d'intérêt.

## Revendications

1. Dispositif de mesure portatif sans contact d'un courant I traversant un conducteur électrique (10A), le dispositif (12) comportant un module de mesure (14) et un module de traitement (16), le module de mesure (14), configuré pour être tenu, par un opérateur, en contact du conducteur dans un plan P sensiblement orthogonal à ce conducteur et en regard et sans enserrement de ce conducteur, comportant une première pluralité de capteurs de champs magnétiques, et le module de traitement (16) étant configuré pour effectuer une combinaison linéaire déterminée de la pluralité de signaux délivrés par la première pluralité de capteurs de champs magnétiques (140-154), de sorte à réaliser un filtrage spatial angulaire isolant le courant I à mesurer d'autres courants perturbateurs parcourant d'autres conducteurs.

2. Dispositif selon la revendication 1, **caractérisé en ce que** le filtrage spatial angulaire est réalisé dans une zone prédéfinie de l'espace, limitée à un secteur circulaire défini par un angle $2\alpha$ et un rayon d et centrée sur le conducteur électrique (10A) disposé à une distance déterminée r + d0 d'un centre de la première pluralité de capteurs, r étant le rayon de la première pluralité de capteurs, d0 la distance de mesure et r + d0 < d.

3. Dispositif selon la revendication 2, **caractérisé en ce que**, pour déterminer la distance de mesure d0, il comporte en outre un doigt de palpation rétractable (18) disposé à l'extrémité du module de traitement et présentant une position de repos et une position déployée, le passage de l'une à l'autre de ces deux positions distantes d'une distance prédéterminée Δd0 s'effectuant par un bouton poussoir (20) actionnable par l'opérateur.

4. Dispositif selon la revendication 2, **caractérisé en ce qu'**il comporte en outre une deuxième pluralité de capteurs de champs magnétiques (140A, 140B) dont le centre est espacé d'une distance prédéterminée Δd0 du centre de la première pluralité de capteurs.

5. Dispositif selon la revendication 1 ou la revendication 2, **caractérisé en ce que** le module de mesure comporte l'une des formes suivantes : circulaire, elliptique, rectangulaire, carrée, en étoile ou en T.

6. Dispositif selon l'une quelconque des revendications 1 à 5, **caractérisé en ce que** les capteurs de champs magnétiques sont répartis à la périphérie du module de mesure.

7. Dispositif selon l'une quelconque des revendications 1 à 6, **caractérisé en ce que** les capteurs de champs magnétiques ont une sensibilité maximale tangentielle et/ou radiale.

8. Dispositif selon l'une quelconque des revendications 1 à 7, **caractérisé en ce que** les capteurs de champs magnétiques sont choisis parmi les capteurs suivants : capteurs à effet Hall, capteurs XMR, capteurs à porte de flux.

9. Dispositif selon l'une quelconque des revendications 1 à 8, **caractérisé en ce que** les capteurs de champs magnétiques sont au nombre de 2 à 30.

10. Dispositif selon la revendication 1, **caractérisé en ce que** le module de traitement est configuré pour reconstruire une image dans le plan P de la disposition angulaire des sources magnétiques formées par les autres conducteurs électriques présents autour du module de mesure.

11. Dispositif selon la revendication 1, **caractérisé en ce que** chaque capteur magnétique est formé de trois capteurs identiques disposés orthogonalement et le module de traitement est configuré pour reconstruire une image 3D de l'environnement magnétique autour du module de mesure.

12. Dispositif selon l'une quelconque des revendications 1 à 11, **caractérisé en ce que**, pour couvrir une plus grande plage de mesure de courant, les capteurs de champs magnétiques alternent des capteurs à forte sensibilité de type à porte de flux et des capteurs à faible sensibilité de type à effet Hall.

**Patentansprüche**

1. Tragbare Vorrichtung zur kontaktlosen Messung eines Stroms I, der einen elektrischen Leiter (10A) durchquert, wobei die Vorrichtung (12) ein Messmodul (14) und ein Verarbeitungsmodul (16) beinhaltet, wobei das Messmodul (14) dazu ausgestaltet ist, von einem Bediener in Kontakt mit dem Leiter in einer Ebene P im Wesentlichen orthogonal zu diesem Leiter und diesem zugewandt und ohne Einklemmen des Leiters gehalten zu werden, und es eine erste Vielzahl von Magnetfeldsensoren beinhaltet, und das Verarbeitungsmodul (16) dazu ausgestaltet ist, eine Linearkombination zu bewirken, die aus der Vielzahl von Signalen bestimmt wird, die von der ersten Vielzahl von Magnetfeldsensoren (140-154) geliefert werden, auf solche Weise, dass eine räumliche Winkelfilterung verwirklicht wird, die den zu messenden Strom I von anderen Störströmen isoliert, die andere Leiter durchströmen.

2. Vorrichtung nach Anspruch 1, **dadurch gekennzeichnet, dass** die räumliche Winkelfilterung in einer vordefinierten Zone des Raums verwirklicht wird, die auf einen Kreissektor, der durch einen Winkel $2\alpha$ und einen Radius d definiert wird, begrenzt ist und auf dem elektrischen Leiter (10A) zentriert ist, der in einem bestimmten Abstand r + d0 von einem Zentrum der ersten Vielzahl von Sensoren angeordnet ist, wobei r der Radius der ersten Vielzahl von Sensoren ist, d0 der Messabstand ist und r + d0 < d ist.

3. Vorrichtung nach Anspruch 2, **dadurch gekennzeichnet, dass** sie zum Bestimmen des Messabstands d0 ferner einen einziehbaren Tastfinger (18) beinhaltet, der an dem Ende des Verarbeitungsmoduls angeordnet ist und eine Ruheposition und eine ausgefahrene Position aufweist, wobei der Übergang von einer dieser zwei Positionen in die andere, die in einem vorbestimmten Abstand Δd0 beabstandet sind, durch einen Schiebeknopf (20) bewirkt wird, der von dem Bediener betätigt werden kann.

4. Vorrichtung nach Anspruch 2, **dadurch gekennzeichnet, dass** sie ferner eine zweite Vielzahl von Magnetfeldsensoren (140A, 140B) beinhaltet, deren Zentrum um einen vorbestimmten Abstand Δd0 von dem Zentrum der ersten Vielzahl von Sensoren beabstandet ist.

5. Vorrichtung nach Anspruch 1 oder Anspruch 2, **dadurch gekennzeichnet, dass** das Messmodul eine der folgenden Formen beinhaltet: kreisförmig, elliptisch, rechteckig, quadratisch, sternförmig oder T-förmig.

6. Vorrichtung nach einem der Ansprüche 1 bis 5, **dadurch gekennzeichnet, dass** die Magnetfeldsensoren über den Umfang des Messmoduls verteilt sind.

7. Vorrichtung nach einem der Ansprüche 1 bis 6, **dadurch gekennzeichnet, dass** die Magnetfeldsensoren eine maximale tangentiale und/oder radiale Empfindlichkeit aufweisen.

8. Vorrichtung nach einem der Ansprüche 1 bis 7, **dadurch gekennzeichnet, dass** die Magnetfeldsensoren aus den folgenden Sensoren ausgewählt sind: Hall-Effekt-Sensoren, XMR-Sensoren, Fluxgate-Sensoren.

9. Vorrichtung nach einem der Ansprüche 1 bis 8, **dadurch gekennzeichnet, dass** die Anzahl der Magnetfeldsensoren von 2 bis 30 beträgt.

10. Vorrichtung nach Anspruch 1, **dadurch gekennzeichnet, dass** das Verarbeitungsmodul so ausgestaltet ist, dass es ein Bild in der P-Ebene der Winkelanordnung der magnetischen Quellen rekonstruiert, die von den anderen elektrischen Leitern gebildet werden, die um das Messmodul herum vorhanden sind.

11. Vorrichtung nach Anspruch 1, **dadurch gekennzeichnet, dass** jeder Magnetsensor aus drei identischen Sensoren gebildet wird, die orthogonal angeordnet sind, und das Verarbeitungsmodul ausgestaltet ist, um ein 3D-Bild der magnetischen Umgebung um das Messmodul herum zu rekonstruieren.

12. Vorrichtung nach einem der Ansprüche 1 bis 11, **dadurch gekennzeichnet, dass** zum Abdecken eines größeren Strommessbereichs die Magnetfeldsensoren zwischen hochempfindlichen Sensoren vom Fluxgate-Typ und Sensoren mit geringer Empfindlichkeit vom Hall-Effekt-Typ alternieren.

**Claims**

1. A portable device for a contactless measurement of a current I passing through an electrical conductor (10A), the device (12) including a measuring module (14) and a processing module (16), the measuring module (14), configured to be held by an operator in contact with the conductor in a plane P substantially orthogonal to this conductor and facing and without clamping this conductor, including a first plurality of magnetic field sensors, and the processing module (16) being configured to perform a determined linear combination of the plurality of signals delivered by the first plurality of magnetic field sensors (140-154), so as to perform an angular spatial filtering isolating the current I to be measured from other disturbing currents passing through other conductors.

2. The device according to claim 1, **characterized in that** the angular spatial filtering is performed in a predefined area of the space, limited to a circular sector defined by an angle $2\alpha$ and a radius d and centered on the electrical conductor (10A) disposed at a determined distance $r + d_0$ from a center of the first plurality of sensors, r being the radius of the first plurality of sensors, $d_0$ the measuring distance and $r + d_0 < d$.

3. The device according to claim 2, **characterized in that**, in order to determine the measuring distance $d_0$, it further includes a retractable sensing finger (18) disposed at the end of the processing module and having a rest position and a deployed position, the switching between these two positions distant by a predetermined distance $\Delta d_0$ being made by a push button (20) actionable by the operator.

4. The device according to claim 2, **characterized in that** it further includes a second plurality of magnetic field sensors (140A, 140B) whose center is spaced at a predetermined distance $\Delta d_0$ from the center of the first plurality of sensors.

5. The device according to claim 1 or 2, **characterized in that** the measuring module includes one of the following shapes: circular, elliptical, rectangular, square, star or T shape.

6. The device according to any one of claims 1 to 5, **characterized in that** the magnetic field sensors are distributed around the periphery of the measuring module.

7. The device according to any one of claims 1 to 6, **characterized in that** the magnetic field sensors have a maximum tangential and/or radial sensitivity.

8. The device according to any one of claims 1 to 7, **characterized in that** the magnetic field sensors are chosen among the following sensors: Hall-effect sensors, xMR sensors, fluxgate sensors.

9. The device according to any one of claims 1 to 8, **characterized in that** the magnetic field sensors are 2 to 30 in number.

10. The device according to claim 1, **characterized in that** the processing module is configured to reconstruct an image in the plane P of the angular disposition of the magnetic sources formed by the other electrical conductors present around the measuring module.

11. The device according to claim 1, **characterized in that** each magnetic sensor is formed of three identical sensors disposed orthogonally and the processing module is configured to reconstruct a 3D image of the magnetic environment around the measuring module.

12. The device according to any one of claims 1 to 11, **characterized in that**, in order to cover a larger current measurement range, the magnetic field sensors alternate between high-sensitivity sensors of the fluxgate type and low-sensitivity sensors of the Hall-effect type.

[Fig. 1]

[Fig. 2]

[Fig. 3]

[Fig. 4]

[Fig. 5]

**EP 3 828 554 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2019146009 A1
- WO 2013051567 A1